# EUROPEAN PATENT APPLICATION

(11) **EP 4 456 247 A1**
(43) Date of publication of application: **30.10.2024**
(21) Application number: 22910729.7
(22) Date of filing: 24.11.2022
(51) Int. Cl.: H01M 10/42, H01M 10/48

(54) **SYSTEM FOR SUPPORTING REUSE OF LITHIUM ION SECONDARY BATTERY**

(30) Priority: 21.12.2021 JP 2021206772
(71) Applicant: NGK Insulators, Ltd., Nagoya city, Aichi 467-8530 (JP)
(72) Inventor: KOBAYASHI, Nobuyuki, Nagoya-city, Aichi 467-8530 (JP); NAKASHIMA, Eiji, Nagoya-city, Aichi 467-8530 (JP); IIDA, Daisuke, Nagoya-city, Aichi 467-8530 (JP); TANAKA, Yuki, Nagoya-city, Aichi 467-8530 (JP)
(74) Representative: Müller-Boré & Partner Patentanwälte PartG mbB
(86) International application number: PCT/JP2022/043358
(87) International publication number: WO 2023/120011

(57) **Abstract**

A reuse support system performs an electrode degradation judgment to judge, based on one or a plurality of kinds of first data diagnosed regarding a ceramic electrode removed from a lithium-ion secondary battery having the ceramic electrode, whether or not a degradation degree of the removed ceramic electrode satisfies a condition for enabling regeneration of the ceramic electrode.

## Description

### TECHNICAL FIELD

The present invention generally relates to reuse of a lithium-ion secondary battery.

### BACKGROUND ART

As a method for reusing the lithium-ion secondary battery (specifically, to reuse the entire lithium-ion secondary battery or its constituent elements), for example, there is known a reuse method (a method for reusing a negative-electrode active material layer) disclosed in PTL 1.

### CITATION LIST

### PATENT LITERATURE

PTL 1: Japanese Patent Application Laid-Open (Kokai) Publication No. 2014-127417

### SUMMARY OF THE INVENTION

### PROBLEMS TO BE SOLVED BY THE INVENTION

The reuse of the lithium-ion secondary battery as mentioned above can be classified broadly into recycling and reuse. The battery recycling involves recovery of materials of, for example, electrodes as active materials or alloys, for which it is necessary to go through complicated processes, thereby resulting in high cost. On other hand, regarding the battery reuse, battery performance is evaluated and the battery is reused by distinguishing between its use purposes according to a degree of degradation. For example, if the degradation degree is low, the battery can be reused for the use in an electric automobile (EV) or a forklift; and if the degradation degree is high, the battery can be reused for the use as a backup power source.

Accordingly, the recycling of the lithium-ion secondary battery requires complicated processes and high cost, in contrast, the purpose of the reuse is limited. Therefore, the current situation is that the reuse of the lithium-ion secondary battery has not advanced so much. Particularly, since such conventional lithium-ion secondary battery containing an organic binder and a conductive assistant in electrodes (typically, a lithium-ion secondary battery which has a current collector and whose electrodes are powder-coated electrodes) have many degradation factors, it is difficult to remove the used electrodes and reuse them directly as electrodes.

It is an object of the present invention to support the reuse of the lithium-ion secondary battery.

### MEANS TO SOLVE THE PROBLEMS

The inventors of the present invention have found that a lithium-ion secondary battery whose performance has sufficiently recovered by replacing an electrolytic solution and performing cleaning and/or heat treatment of a battery element regarding a used lithium-ion secondary battery in which at least one electrode of a positive electrode and a negative electrode is a ceramic electrode (specifically, for example, a used lithium-ion secondary battery of a sintered body type, which is equipped with a battery element including a ceramic positive electrode layer, a ceramic separator, and a ceramic negative electrode layer) can be reassembled through simple procedures and at low cost.

So, the lithium-ion secondary battery having the ceramic electrode(s) is adopted as the lithium-ion secondary battery. Then, a reuse support system which is a computer system for supporting the reuse of that lithium-ion secondary battery is constructed.

The reuse support system performs an electrode degradation judgment to judge, based on one or a plurality of kinds of first data of diagnosis of the ceramic electrode removed from the lithium-ion secondary battery having the ceramic electrode, whether or not a degradation degree of the removed ceramic electrode satisfies a condition for enabling regeneration of the ceramic electrode.

### ADVANTAGEOUS EFFECTS OF THE INVENTION

The reuse of the lithium-ion secondary battery can be supported.

### BRIEF DESCRIPTION OF DRAWINGS

Fig. 1 is a schematic sectional view of one example of a lithium-ion secondary battery according to one embodiment of the present invention;
Fig. 2 is a SEM image showing one example of a cross-sectional surface perpendicular to a layer plane of an oriented positive electrode layer;
Fig. 3 is an EBSD image of a cross-sectional surface of the oriented positive electrode layer shown in Fig. 2;
Fig. 4 is a histogram indicating a distribution of orientation angles of primary particles in the EBSD image in Fig. 3;
Fig. 5 is a diagram illustrating an example of a value chain according to a comparative example;
Fig. 6 is a diagram illustrating an example of a value chain according to an embodiment;
Fig. 7 is a configuration diagram of the entire reuse system including a reuse support system according to an embodiment;
Fig. 8 is a configuration diagram of the reuse support system;
Fig. 9 is a flowchart illustrating a flow of reusing a lithium-ion secondary battery;
Fig. 10 is a flowchart illustrating the details of S907 in Fig. 9; and
Fig. 11 is a flowchart illustrating the details of S908 in Fig. 9.

### DESCRIPTION OF EMBODIMENTS

In the description indicated below, an "interface apparatus" may be one or more interface devices. The one or more interface devices may be at least one of the following:
- One or more I/O (Input/Output) interface devices. The I/O (Input/Output) interface device is an interface device for at least one of an I/O device and a remote display computer. The I/O interface device for the display computer may be a communication interface device. At least one I/O device may be a user interface device, for example, either one of input devices such as a keyboard and a pointing device, and output devices such as a display device.
- One or more communication interface devices. The one or more communication interface devices may be one or more communication interface devices of the same type (for example, one or more NICs [Network Interface Cards]) or two or more communication interface devices of different types (for example, an NIC and an HBA [Host Bus Adapter]).

Furthermore, in the description indicated below, a "memory" is one or more memory devices, which are one example of one or more storage devices, and may typically be a main storage device. At least one memory device in the memory may be a volatile memory device or a nonvolatile memory device.

Furthermore, in the description indicated below, a "persistent storage apparatus" may be one or more persistent storage devices which are one example of one or more storage devices. The persistent storage device may be typically a nonvolatile storage device (such as an auxiliary storage device) and may be specifically, for example, an HDD (Hard Disk Drive), an SSD (Solid State Drive), an NVME (Non-Volatile Memory Express) drive, or an SCM (Storage Class Memory).

Furthermore, in the description indicated below, a "storage apparatus" may be a memory and at least a memory for the persistent storage apparatus.

Furthermore, in the description indicated below, a "processor" may be one or more processor devices. At least one processor device may be typically a microprocessor device like a CPU (Central Processing Unit), but may be a processor device of a different type like a GPU (Graphics Processing Unit). At least one processor device may be of a single-core type or a multi-core type. At least one processor device may be a processor core. At least one processor device may be a processor device in a broad sense such as a circuit which is an aggregate of gate arrays by means of hardware description languages for performing a part or whole of processing (such as an FPGA [Field-Programmable Gate Array], CPLD [Complex Programmable Logic Device], or ASIC [Application Specific Integrated Circuit]).

Furthermore, in the description indicated below, a function may be sometimes described by an expression like "yyy unit"; however, the function may be implemented by execution of one or more computer programs by a processor, or may be implemented by one or more hardware circuits (such as FPGA or ASIC), or may be implemented by a combination of the above. If the function is implemented by the execution of a program by the processor, specified processing is performed by using, for example, the storage apparatus and/or the interface apparatus as appropriate and, therefore, the function may be considered as at least part of the processor. The processing explained by referring to the function as a subject may be the processing executed by the processor or an apparatus which has that processor. The program may be installed from a program source. The program source may be, for example, a program distribution computer or a computer-readable recording medium (such as a non-transitory recording medium). An explanation of each function is one example and a plurality of functions may be gathered as one function or one function may be divided into a plurality of functions.

One embodiment of the present invention will be explained below with reference to the drawings.

Firstly, an explanation will be provided about one example of a lithium-ion secondary battery having a ceramic electrode and a method for reusing the lithium-ion secondary battery.

### <Lithium-Ion Secondary Battery Reusing Method>

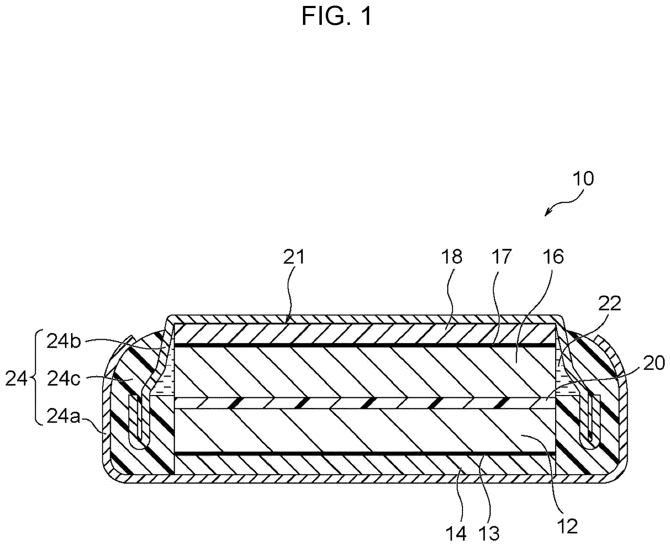

The lithium-ion secondary battery is a sintered-body-type battery (semi-solid battery) equipped with a battery element, including a ceramic positive electrode layer, a ceramic separator, and a ceramic negative electrode layer, together with an electrolytic solution. Fig. 1 schematically illustrates one example of such a sintered-body-type lithium-ion secondary battery. Incidentally, a lithium-ion secondary battery 10 illustrated in Fig. 1 is in a coin-cell battery form; however, the lithium-ion secondary battery having the ceramic electrode according to the present invention is not limited to this example and may be a battery of other forms such as a button-type battery, a cylindrical battery, a square battery, a pack-type battery, a car battery, and a sheet battery.

Specifically speaking, regarding a method for reusing the lithium-ion secondary battery, firstly a used lithium-ion secondary battery 10 equipped with a battery element 21 including a ceramic positive electrode layer 12, a ceramic separator 20, and a ceramic negative electrode layer 16, an electrolytic solution 22, and a battery container 24 for receiving the battery element 21 and the electrolytic solution 22 is prepared. Then, after removing the battery element 21 from the lithium-ion secondary battery 10, the electrolytic solution 22 in the lithium-ion secondary battery 10 is replaced with a fresh electrolytic solution 22. Next, electrode restoration processing including cleaning and/or heat treatment is applied to the battery element 21. Lastly, the battery element 21 to which the electrode restoration processing has been applied is put back into the battery container 24, thereby assembling the lithium-ion secondary battery 10. Accordingly, by replacing the electrolytic solution 22 and performing cleaning and/or heat treatment of the battery element 21 for the used lithium-ion secondary battery 10 of the sintered body type, which is equipped with the battery element 21 including the ceramic positive electrode layer 12, the ceramic separator 20, and the ceramic negative electrode layer 16, it is possible to reassemble the lithium-ion secondary battery 10, whose performance has recovered sufficiently, through simple procedures and at low cost.

The recycling of a lithium-ion secondary battery requires complicated processes and high cost, the purpose of its reuse is limited as explained earlier. Therefore, the current situation is that the reuse of the lithium-ion secondary battery or its constituent elements has not advanced so much. Particularly, since the conventional lithium-ion secondary battery which includes an organic binder and a conductive assistant in its electrodes has many degradation factors, it is difficult to remove the used electrode and reuse it directly as an electrode after removing it. This problem is solved in this embodiment. This will be explained below.

Firstly, various factors can be considered as common degradation factors of the conventional lithium-ion secondary battery. Firstly, when creating a battery or at an initial stage of using the battery, there occur a reaction between moisture contained in an electrolyte and PF⁵- which is electrolyte anions, a reaction between PF⁵ and HF, which are generated by the above-mentioned reaction, and a solvent, a reaction between the electrolyte and an active material(s), generation of a carbonate layer and a fluorinated layer on the electrode surface, which is caused by side effects of the above reaction, and generation of gas. Next, the use of the battery causes degradation and reduction of the active material itself which is used in an active material layer of the electrode. Repetition of electric charging/discharging induces cracking of particles due to expansion/contraction changes of the particles, structure degradation and destruction of the structure due to phase changes and distortion, dissolution of a positive-electrode active material, precipitation of the dissolved substance at the negative electrode, short circuit between the positive electrode and the negative electrode caused by the above, reduction of lithium ions, generation of Li dendrite at the negative electrode by operation at low temperature or operation at a large current, reduction of lithium ions and short circuit between the positive electrode and the negative electrode which are caused by the above, and degradation of an interface. Moreover, there occur corrosion of a surface of the current collector, peeling off of the active material from the current collector, reduction of conductivity of the electrodes, changes and disproportionation of a conductive net in the active material layer, degradation of the binder, clogging of the separator, and increase of internal resistance of cells due to these changes. Furthermore, various factors depending on use conditions, such as reduction of a reaction amount of the active material due to overcharge and overdischarge, oxidation of the electrolytic solution, degradation by a reduction reaction, degradation of a reaction interface layer, and degradation attributable to expansion and contraction of the electrode upon electric charging/discharging can be listed as causes for capacity degradation.

On the contrary, the used lithium-ion secondary battery according to this embodiment is a sintered-body-type battery (hereinafter referred to as a "semi-solid battery") equipped with the battery element 21 including the ceramic positive electrode layer 12, the ceramic separator 20, and the ceramic negative electrode layer 16, as well as the electrolytic solution 22; and there are few degradation factors regarding a common lithium-ion secondary battery and the battery element 21 is a ceramic configuration and is thereby robust, and the battery can be reassembled by repeatedly replacing the electrolytic solution 22. Advantageously, among a wide variety of degradation factors mentioned above, there are two main degradation modes regarding the semi-solid battery, that is, a "reaction between the electrolyte and the active material" and "dissolution of the positive-electrode active material." Specifically speaking, the respective layers of the battery element 21 in the semi-solid battery are made of ceramics (that is, a sintered body), so that no component which will become a degradation factor like an organic binder is included (the organic binder will be lost due to sintering). As a result, the ceramic electrode which does not include the binder or the like suffers few degradation (no degradation derived from the binder). Moreover, the structure of the positive electrode / separator / negative electrode layers is made of ceramics, so that it can be removed in its original form even after use and it can be handled easily. What is more, this structure is a single ceramic body (even if a metal foil is bonded to it, the metal foil can be removed or peeled off), so that not only cleaning, but also heat treatments such as degreasing and calcination are possible. Of course, degradation by oxidative decomposition of the electrolytic solution 22 may occur, but the ceramic electrode itself will rarely degrade. So, the performance of the battery can be recovered to a certain degree by simply replacing the electrolytic solution 22. Therefore, if the method according to this embodiment is employed, the lithium-ion secondary battery whose performance has recovered sufficiently can be reassembled through simple procedures and at low cost by using the used lithium-ion secondary battery.

### (1) Preparation of Used Lithium-Ion Secondary Battery

The used lithium-ion secondary battery 10 is prepared. This lithium-ion secondary battery 10 is a sintered-body-type battery (semi-solid battery) equipped with: the battery element 21 including the ceramic positive electrode layer 12, the ceramic separator 20, and the ceramic negative electrode layer 16; the electrolytic solution 22; and the battery container for receiving the battery element 21 and the electrolytic solution 22. Particularly, it is preferable in terms of improvement of work efficiency that the ceramic positive electrode layer 12, the ceramic separator 20, and the ceramic negative electrode layer 16 constitute one integrated sintered body as a whole because the ceramic positive electrode layer 12, the ceramic negative electrode layer 16, and the separator 20 do not have to be handled separately, but can be handled on the basis of the integrated sintered body. The battery element may further include a positive-electrode current collector 14 and/or a negative-electrode current collector 18.

### (2) Removal of Battery Element

The battery element 21 is removed from the lithium-ion secondary battery 10 (specifically, the battery container 24). In order to remove the battery element 21, it is only necessary to remove part of the battery container 24 (for example, a negative electrode can 24b) to open the inside of the battery and then take out the battery element 21 and the removal of the battery element 21 may be performed as appropriate according to the configuration of the battery container 24. Particularly, when the ceramic positive electrode layer 12, the ceramic separator 20, and the ceramic negative electrode layer 16 constitute one integrated sintered body as a whole, it is advantageous because of easy workability that the whole integrated sintered body can be taken out of the battery container 24.

### (3) Replacement of Electrolytic Solution

The electrolytic solution 22 inside the lithium-ion secondary battery 10 (specifically, inside the battery container 24) is replaced with a fresh electrolytic solution 22. The replacement of the electrolytic solution 22 should preferably be performed after removing the battery element 21, but there is no limitation to this example. For example, when replacing the battery container 24, the fresh electrolytic solution 22 should only be put in another battery container 24 for replacement. The fresh electrolytic solution 22 may have the same composition as that of the electrolytic solution 22 which was originally used for the lithium-ion secondary battery 10 or an electrolytic solution 22 with a different composition from that of the originally used electrolytic solution 22 may be used as long as it can exert permissible performance. For example, an electrolytic solution 22 which gives rise to better performance as compared to the originally used electrolytic solution may be used. The details of the preferable electrolytic solution 22 will be described later.

### (4) Electrode Restoration Processing

Electrode restoration processing including cleaning and/or heat treatment is applied to the battery element 21. A method of the electrode restoration processing is not particularly limited as long as it is the cleaning and/or heat treatment that can improve the electrode performance of the degraded electrode. Typically, the electrode restoration processing is performed by cleaning the battery element 21 with a polar solvent to remove impurities contained in and/or attached to the battery element 21 and then drying it. The polar solvent may be either a non-aqueous solvent or water. Examples of the non-aqueous solvent include NMP (N-methyl-2-pyrrolidone), ethanol, etc. The cleaning method with the polar solvent is not particularly limited, but it is preferable to perform the cleaning by immersing the battery element 21 in the polar solvent and performing ultrasonic cleaning or stirring.

The cleaned and dried battery element 21 at 300 to 1000°C should preferably be heated because the electrode performance can be further enhanced. Since the battery element 21 is a single ceramic body (excluding the positive-electrode current collector 14 and/or the negative-electrode current collector 18), heat treatment such as degreasing or calcination can be performed (which cannot be performed on a coated electrode containing an active material or a binder). In this case, the battery element 21 should preferably be degreased and/or calcinated, more preferably both degreased and calcinated. The degreasing of the battery element 21 may be performed by heating the battery element preferably at 300 to 600°C, more preferably at 400 to 600°C, and the preferred retention time in the above-described temperature range is 0.5 to 20 hours, more preferably 2 to 20 hours. Accordingly, unnecessary components or impurities (such as SEI) remaining in the battery element 21 can be eliminated or calcinated, and the residual amount can be further reduced to further enhance the battery performance. The calcination of the battery element 21 may be performed by heating the battery element preferably at 650 to 1000°C, more preferably at 700 to 950°C, and the preferred retention time in the above-described temperature range is 0.01 to 20 hours, more preferably 0.01 to 15 hours. Consequently, the crystallinity of the material can be restored or improved, and the battery performance can be further enhanced. Moreover, the strength of the electrode active material layer can be improved by further calcinating the electrode active material. Moreover, by having lithium compounds coexist and/or adopting a lithium-containing atmosphere during the heat treatment such as degreasing or calcination, it is possible to optimize the lithium content in the electrode active material and promote the performance recovery of the positive electrode layer 12 and/or the negative electrode layer 16.

Incidentally, if the battery element 21 further includes the positive-electrode current collector 14 and/or the negative-electrode current collector 18, it is preferred that the positive-electrode current collector 14 and/or the negative-electrode current collector 18 be removed before and/or during the cleaning and that the positive-electrode current collector 14 and/or the negative-electrode current collector 18 be attached to the battery element 21 after the electrode restoration processing. By doing so, the single ceramic body can be cleaned and heat-treated as described above. The positive-electrode current collector 14 and/or the negative-electrode current collector 18 attached to the battery element 21 after the electrode restoration processing is not limited to a new positive-electrode current collector 14 and/or negative-electrode current collector 18, and the removed positive-electrode current collector 14 and/or the negative-electrode current collector 18 may be reused.

### (5) Battery Assembly

The battery element 21 to which the electrode restoration processing has been applied is put back into the battery container 24 to assemble the lithium-ion secondary battery 10. At this time, at least some parts constituting the battery container 24 may be replaced with new parts. Alternatively, the battery container 24 may be replaced with another battery container 24 after the battery element 21 is removed and before it is returned to the battery container 24.

### <Lithium-Ion Secondary Battery>

As illustrated in Fig. 1, the lithium-ion secondary battery 10 is equipped with a ceramic positive electrode layer 12 (hereinafter referred to as a positive electrode layer 12), a ceramic negative electrode layer 16 (hereinafter referred to as a negative electrode layer 16), a ceramic separator 20 (hereinafter referred to as a separator 20), an electrolytic solution 22, and a battery container 24. The positive electrode layer 12 is composed of ceramics such as a lithium composite oxide sintered lithium body. The negative electrode layer 16 is composed of ceramics such as a titanium-containing sintered body. The separator 20 is interposed between the positive electrode layer 12 and the negative electrode layer 16. The electrolytic solution 22 is impregnated into the positive electrode layer 12, the negative electrode layer 16, and the separator 20. The battery container 24 includes a sealed space, in which the positive electrode layer 12, the negative electrode layer 16, the separator 20, and the electrolytic solution 22 are housed.

The positive electrode layer 12 is composed of a lithium composite oxide sintered body. The fact that the positive electrode layer 12 is composed of a sintered body means that the positive electrode layer 12 does not contain a binder or a conductive assistant. This is because even if a binder is contained in the green sheet, the binder is lost or burned during calcination. Then, since the positive electrode layer 12 does not contain a binder, it has an advantage that degradation of the positive electrode by the electrolytic solution 22 can be avoided. Incidentally, it is particularly preferable that the lithium composite oxides constituting the sintered body should be lithium cobaltate (typically, LiCoO₂ (hereinafter referred to as LCO)). Various lithium composite oxide sintered body plates or LCO sintered body plates are known.

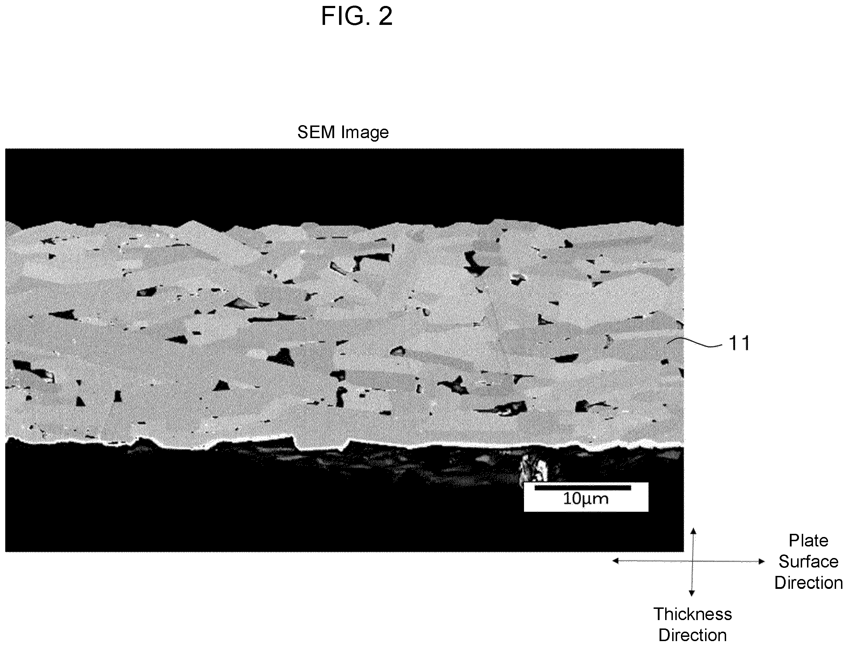

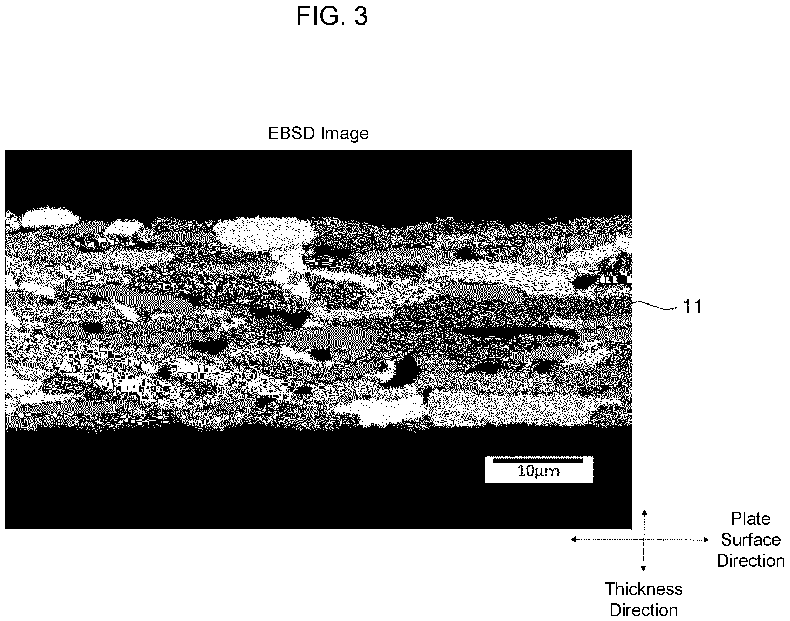

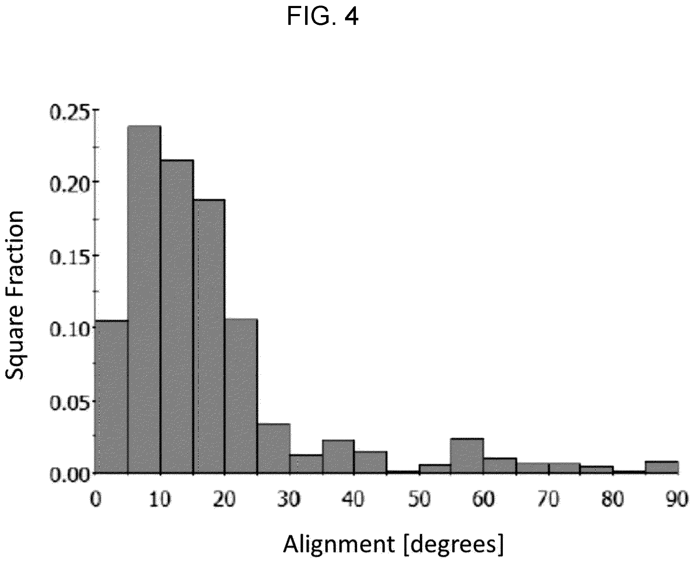

According to a preferred embodiment, the positive electrode layer 12, that is, the lithium composite oxide sintered body plate is an oriented positive electrode layer containing a plurality of primary practices composed of lithium composite oxides, wherein the plurality of primary particles are oriented at an average orientation angle of more than 0° or less than or equal to 30° with respect to a layer plane of the positive electrode layer. Since the oriented positive electrode layer is oriented as described above, there is little structural damage due to expansion and contraction caused by electric charging/discharging and it is particularly suitable for reuse. Fig. 2 shows an example of a cross-sectional SEM image perpendicular to the layer plane of the oriented positive electrode layer 12, while Fig. 3 shows an electron backscatter diffraction (EBSD) image in a cross-section perpendicular to the layer plane of the oriented positive electrode layer 12. Moreover, Fig. 4 is a histogram showing the distribution of orientation angles of the primary particles 11 in the EBSD image of Fig. 3 on area standard. In the EBSD image shown in Fig. 3, discontinuities in crystal orientation can be observed. In Fig. 3, an orientation angle of each primary particles 11 is indicated by a shade of color and a darker color indicates a smaller orientation angle. The orientation angle is an inclination angle formed by the (003) plane of each primary particle 11 with respect to the layer plane direction. Incidentally, in Figs. 2 and 3, portions displayed in black inside the oriented positive electrode layer 12 are pores.

The oriented positive electrode layer 12 is an oriented sintered body composed of a plurality of primary particles 11 bonded to each other. Each primary particle 11 is mainly of a plate shape, but primary particles formed in, for example, cuboid, cube, and spherical shapes may be included. The cross-sectional shape of each primary particle 11 is not particularly limited and may be rectangular, polygonal other than rectangular, circular, elliptical, or other complex shapes.

Each primary particle 11 is composed of a lithium composite oxide. The lithium composite oxide is an oxide represented by LiₓMO₂ (0.05 < x < 1.10, where M is at least one kind of transition metal and M typically includes one or more kinds of Co, Ni, and Mn). The lithium composite oxide has a layered rock-salt structure. The layered rock-salt structure is a crystal structure in which a lithium layer and a transition metal layer other than lithium are alternately stacked with a layer of oxygen between them, that is, a crystal structure in which a transition metal ion layer and a single lithium layer are alternately stacked via oxide ions (typically an α-NaFeO₂ type structure, that is, a structure in which a transition metal and lithium are aligned regularly in the direction of
axis of the cubic rock salt type structure). Examples of the lithium composite oxide include LiₓCoO₂ (lithium cobaltate), LiₓNiO₂ (lithium nickelate), LiₓMnO₂ (lithium manganate), LiₓNiMnO₂ (nickel lithium manganate), LiₓNiCoO₂ (lithium nickel cobaltate), LiₓCoNiMnO₂ (cobalt nickel lithium manganate), LiₓCoMnO₂ (cobalt lithium manganate), and so on, and particularly LiₓCoO₂ (lithium cobaltate, typically LiCoO₂) is preferred. The lithium composite oxide may contain one or more elements selected from Mg, Al, Si, Ca, Ti, V, Cr, Fe, Cu, Zn, Ga, Ge, Sr, Y, Zr, Nb, Mo, Ag, Sn, Sb, Te, Ba, Bi, and W.

As shown in Figs. 3 and 4, an average value of the orientation angle of each primary particle 11, i.e., an average orientation angle is more than 0° and less than or equal to 30°. This provides the following various advantages. Firstly, since each primary particle 11 is in a state of lying in an inclined direction with respect to the thickness direction, adhesion between the primary particles can be improved. As a result, since the lithium-ion conductivity between a certain primary particle 11 and other primary particles 11 adjacent to both sides of the primary particle 11 in the longitudinal direction can be improved, rate characteristics can be improved. Secondly, the rate characteristics can be further improved. This is because, as described above, the expansion and contraction of the oriented positive electrode layer 12 in the thickness direction predominate over the layer plane direction upon the entry and exit of lithium ions, so that the expansion and contraction of the oriented positive electrode layer 12 becomes smooth, and accordingly the entry and exit of lithium ions become smooth. Thirdly, since the expansion and contraction of the oriented positive electrode layer 12 due to the entry and exit of lithium ions predominate in the direction perpendicular to the layer plane, stress at a junction interface between the oriented positive electrode layer 12 and the separator 20 is hardly generated, and good bonding at the interface is easily maintained.

The average orientation angle of the primary particles 11 is obtained by the following method. Firstly, in an EBSD image as shown in Fig. 3, in which a rectangular area of 95 µm × 125 µm was observed at 1000-fold magnification, three horizontal lines dividing the oriented positive electrode layer 12 into four equal portions in the thickness direction and three vertical lines dividing the oriented positive electrode layer 12 into four equal portions in the layer plane direction are drawn. Next, the average orientation angle of the primary particles 11 is obtained by arithmetically averaging the orientation angles of all the primary particles 11 intersecting at least one of the three horizontal lines and the three vertical lines. The average orientation angle of the primary particles 11 should preferably be 30° or less, more preferably 25° or less, from the viewpoint of further improving the rate characteristics. The average orientation angle of the primary particles 11 should preferably be 2° or more, more preferably 5° or more, from the viewpoint of further improving the rate characteristics.

As shown in Fig. 4, the orientation angles of the respective primary particles 11 may be widely distributed from 0° to 90°, but most of them should preferably be distributed in an area greater than 0° and less than or equal to 30°. That is, when the cross-section of the oriented sintered body constituting the oriented positive electrode layer 12 is analyzed by EBSD, the total area of the primary particles 11 (hereinafter referred to as low angle primary particles) whose orientation angle with respect to a layer plane of the oriented positive electrode layer 12 among the primary particles included in the analyzed cross-section is greater than 0° and less than or equal to 30° should preferably be 70% or more, more preferably 80% or more, of the total area of the primary particles 11 (specifically, 30 primary particles 11 used to calculate the average orientation angle) included in the cross-section. As a result, a ratio of the primary particles 11 having high mutual adhesiveness can be increased, and thus the rate characteristics can be further improved. Furthermore, the total area of the low angle primary particles having an orientation angle of 20° or less should preferably be 50% or more of the total area of the 30 primary particles 11 used to calculate the average orientation angle. Furthermore, the total area of the low angle primary particles having the orientation angle of 10° or less should preferably be 15% or more of the total area of the 30 primary particles 11 used to calculate the average orientation angle.

Since each primary particle 11 has mainly a plate shape, as shown in Figs. 2 and 3, cross-sections of the respective primary particles 11 extend in a predetermined direction and are typically substantially rectangular. That is, when the cross-section of the oriented sintered body is analyzed by EBSD, the total area of the primary particles 11 having an aspect ratio of 4 or more among the primary particles 11 included in the analyzed cross-section should preferably be 70% or more, more preferably 80% or more, of the total area of the primary particles 11 included in the cross-section (specifically, the 30 primary particles 11 used to calculate the average orientation angle). Specifically, in the EBSD image shown in Fig. 3, the mutual adhesiveness between the primary particles 11 can be improved, and as a result, the rate characteristics can be further improved. The aspect ratio of the primary particles 11 is a value obtained by dividing the maximum Feret diameter of the primary particles 11 by the minimum Feret diameter. The maximum Feret diameter is the maximum distance between two parallel straight lines when the primary particles 11 are sandwiched between the two parallel straight lines in the EBSD image with which the cross-section was observed. The minimum Feret diameter is the minimum distance between the two parallel straight lines when the primary particles 11 are sandwiched between them in the EBSD image.

The average particle size of a plurality of primary particles constituting the oriented sintered body should preferably be 5 µm or more. Specifically, the average particle size of the 30 primary particles 11 used to calculate the average orientation angle should preferably be 5 µm or more, more preferably 7 µm or more, and even more preferably 12 µm or more. As a result, the number of grain boundaries between the primary particles 11 in the direction in which the lithium ions are conducted is reduced, and the overall lithium-ion conductivity is improved, so that the rate characteristics can be further improved. The average particle size of the primary particles 11 is an arithmetic average of the equivalent circle diameter of each primary particle 11. The equivalent circle diameter is the diameter of a circle having the same area as each primary particle 11 in the EBSD image.

The positive electrode layer 12 should preferably contain pores. If the sintered body contains pores, especially open pores, and when it is incorporated into the battery as a positive electrode plate, the electrolytic solution can permeate into the sintered body and, as a result, the lithium-ion conductivity can be improved. This is because the conduction of lithium ions in the sintered body has two types, that is, the conduction through the constituent particles of the sintered body and the conduction through the electrolytic solution in the pores; and the conduction through the electrolytic solution in the pores is overwhelmingly faster.

The positive electrode layer 12, that is, the lithium composite oxide sintered body should preferably have porosity of 20 to 60%, more preferably 25 to 55%, even more preferably 30 to 50%, and particularly preferably 30 to 45%. Since the stress release effect due to the pores and the capacity enhancement can be expected and the mutual adhesiveness between the primary particles 11 can be improved, the rate characteristics can be further improved. The porosity of the sintered body is calculated by polishing the cross-section of the positive electrode layer with CP (cross-section polisher) polishing and then performing SEM observations at 1000 magnification and binarizing the obtained SEM image. The average equivalent circle diameter of each pore formed in the oriented sintered body is not particularly limited, but should preferably be 8 µm or less. The smaller the average equivalent circle diameter of each pore is, the further the mutual adhesiveness between the primary particles 11 can be improved; and, as a result, the rate characteristics can be further improved. The average equivalent circle diameter of the pores is the arithmetic average of the equivalent circle diameters of 10 pores in the EBSD image. The equivalent circle diameter is the diameter of a circle having the same area as each pore in the EBSD image. Each pore formed inside the oriented sintered body should preferably be an open pore leading to the outside of the positive electrode layer 12.

The average pore diameter of the positive electrode layer 12, that is, the lithium composite oxide sintered body should preferably be 0.1 to 10.0 µm, more preferably 0.2 to 5.0 µm, and even more preferably 0.25 to 3.0 µm. Within the above-described range, the occurrence of stress concentration in a local area of large pores is suppressed, and the stress in the sintered body is easily released uniformly.

The thickness of the positive electrode layer 12 should preferably be 60 to 450 µm, more preferably 70 to 350 µm, and even more preferably 90 to 300 µm. Within such a range, the active material capacity per unit area can be increased to improve the energy density of the lithium-ion secondary battery 10, and the degradation of the battery characteristics (especially the increase of the resistance value) caused by the repetition of the electric charging/discharging can be suppressed.

The negative electrode layer 16 is composed of a titanium-containing sintered body. The titanium-containing sintered body should preferably contain lithium titanate Li₄Ti₅O₁₂ (hereinafter referred to as LTO) or niobium titanium composite oxide Nb₂TiO₇, more preferably LTO. Incidentally, LTO is typically known as having a spinel-type structure, but it can have other structures during the electric charging/discharging. For example, a reaction of LTO proceeds in two-phase coexistence of Li₄Ti₅O₁₂ (spinel structure) and Li₇Ti₅O₁₂ (rock salt structure) during the electric charging/discharging. Therefore, LTO is not limited to the spinel structure.

The fact that the negative electrode layer 16 is composed of a sintered body means that the negative electrode layer 16 does not contain a binder or a conductive assistant. This is because even if a binder is included in the green sheet, the binder is lost or burned down during calcination. Since the negative electrode layer does not contain a binder, the packing density of the negative-electrode active material (for example, LTO or Nb₂TiO₇) is increased and a high capacity and good electric charging/discharging efficiency can be obtained.

The negative electrode layer 16, that is, the titanium-containing sintered body has a structure in which a plurality of (i.e., a large number of) primary particles are bonded. Therefore, these primary particles should preferably be composed of LTO or Nb₂TiO₇.

The thickness of the negative electrode layer 16 should preferably be 70 to 500 µm, preferably 85 to 400 µm, and more preferably 95 to 350 µm. The thicker the negative electrode layer 16 is, the easier it is to realize a battery with high capacity and high energy density. The thickness of the negative electrode layer 16 can be obtained, for example, by measuring the distance between the layer planes observed substantially in parallel when the cross-section of the negative electrode layer 16 is observed by SEM (scanning electron microscope).

The primary particle size, which is an average particle size of the plurality of primary particles constituting the negative electrode layer 16, should preferably be 1.2 µm or less, more preferably 0.02 to 1.2 µm, and even more preferably 0.05 to 0.7 µm. Within such a range, both the lithium-ion conductivity and the electronic conductivity can be easily achieved and contribute to the improvement of the rate performance.

The negative electrode layer 16 should preferably contain pores. Since the sintered body contains pores, especially open pores, and when it is incorporated into the battery as a negative electrode layer, the electrolytic solution can permeate into the sintered body, thereby improving the lithium-ion conductivity. This is because when the conduction of lithium ions in the sintered body has two types, that is, the conduction through the constituent particles of the sintered body and the conduction through the electrolytic solution in the pores; and the conduction through the electrolytic solution in the pores is overwhelmingly faster.

The porosity of the negative electrode layer 16 should preferably be 20 to 60%, more preferably 30 to 55%, and even more preferably 35 to 50%. Within such a range, both the lithium-ion conductivity and the electronic conductivity can be easily achieved and contribute to the improvement of the rate performance.

An average pore diameter of the negative electrode layer 16 is 0.08 to 5.0 µm, preferably 0.1 to 3.0 µm, and more preferably 0.12 to 1.5 µm. Within such a range, both the lithium-ion conductivity and the electronic conductivity can be easily achieved and contribute to the improvement of the rate performance.

The separator 20 is a microporous membrane made of ceramics. The separator 20 has an advantage that it is not only excellent in heat resistance, but also can be manufactured as one integral sintered body plate as a whole together with the positive electrode layer 12 and the negative electrode layer 16. The ceramics included in the separator 20 should preferably be at least one kind selected from MgO, Al₂O₃, ZrO₂, SiC, Si₃N₄, AlN, and cordierite, and more preferably at least one kind selected from MgO, Al₂O₃, and ZrO₂. The thickness of the separator 20 should preferably be 3 to 40 µm, more preferably 5 to 35 µm, and even more preferably 10 to 30 µm. The porosity of the separator 20 should preferably be 30 to 85%, and more preferably 40 to 80%.

The separator 20 may contain a glass component from the viewpoint of improving adhesiveness with the positive electrode layer 12 and the negative electrode layer 16. In this case, the content percentage of the glass component in the separator 20 should preferably be 0.1 to 50 weight%, more preferably 0.5 to 40 weight%, and even more preferably 0.5 to 30 weight% with respect to the total weight of the separator 20. The addition of the glass component to the separator 20 should preferably be performed by adding glass frit to the raw material powder of the ceramic separator. Needless to say, if the desired adhesiveness between the separator 20 and the positive electrode layer 12 and the negative electrode layer 16 can be ensured, it is not particularly necessary for the glass component to be included in the separator.

The positive electrode layer 12, the separator 20, and the negative electrode layer 16 should preferably form one integral sintered body plate as a whole, whereby the positive electrode layer 12, the separator 20, and the negative electrode layer 16 should preferably be bonded to each other. That is, it is preferable that the three layers, that is, the positive electrode layer 12, the separator 20, and the negative electrode layer 16 should be bonded to each other without resorting to other bonding techniques such as an adhesive. Under this circumstance, "forming one integral sintered body plate as a whole" means that a green sheet having a three-layer structure consisting of a positive electrode green sheet providing the positive electrode layer 12, a separator green sheet providing the separator 20, and a negative electrode green sheet providing the negative electrode layer 16 is calcinated, and each layer is in a sintered state. Therefore, if the green sheet having the three-layer structure before calcination is punched out into a predetermined shape (for example, a coin shape or a chip shape), there will be no deviation between the positive electrode layer 12 and the negative electrode layer 16 in the integrated sintered body plate in the final form. Specifically speaking, since the end face of the positive electrode layer 12 is aligned with the end face of the negative electrode layer 16, the capacity can be maximized. Alternatively, even if misalignment exists, the integral sintered body plate is suitable for laser machining, cutting, polishing, etc., so that the end faces may be finished to minimize or eliminate such misalignment. In any case, as long as it is an integral sintered body plate, the positive electrode layer 12, the separator 20, and the negative electrode layer 16 are bonded to each other, so that no deviation will occur afterwards between the positive electrode layer 12 and the negative electrode layer 16. By minimizing or eliminating the deviation between the positive electrode layer 12 and the negative electrode layer 16 in this manner, a high electric discharge capacity as expected (i.e., close to theoretical capacity) can be obtained. Moreover, since it is the integral sintered body plate having the three-layer structure including the ceramic separator, it is less likely to cause undulations or warpage (i.e., excellent flatness is achieved) than a single positive electrode plate or a single negative electrode plate manufactured as one sintered body plate and, therefore, the distance between the positive and negative electrodes is less likely to vary (i.e., becomes uniform), thereby contributing to the improvement of electric charging/discharging cycle performance.

The electrolytic solution 22 is not particularly limited, and a commercially available electrolytic solution for lithium batteries, such as a liquid obtained by dissolving lithium salt (for example, LiPF₆) in a non-aqueous solvent of an organic solvent (for example, a mixed solvent of ethylene carbonate (EC) and methyl ethyl carbonate (MEC), a mixed solvent of ethylene carbonate (EC) and diethyl carbonate (DEC), or a mixed solvent of ethylene carbonate (EC) and ethyl methyl carbonate (EMC)) may be used.

To produce a lithium-ion secondary battery having excellent heat resistance, the electrolytic solution 22 should preferably contain lithium borofluoride (LiBF₄) in the non-aqueous solvent. In this case, a preferred non-aqueous solvent is at least one kind selected from a group consisting of γ-butyrolactone (GBL), ethylene carbonate (EC), and propylene carbonate (PC), more preferably a mixed solvent consisting of EC and GBL, a sole solvent consisting of PC, a mixed solvent consisting of PC and GBL, or a sole solvent consisting of GBL, and particularly preferably a mixed solvent consisting of EC and GBL or a sole solvent consisting of GBL. The non-aqueous solvent contains γ-butyrolactone (GBL), which increases a boiling point and greatly improves the heat resistance. From the viewpoint of the above, a volume ratio of EC to GBL (EC:GBL) in the EC- and/or GBL-containing non-aqueous solvent should preferably be 0:1 to 1:1 (GBL ratio 50 to 100 volume%), more preferably 0:1 to 1:1.5 (GBL ratio 60 to 100 volume%), even more preferably 0:1 to 1:2 (GBL ratio 66.6 to 100 volume%), and particularly preferably 0:1 to 1:3 (GBL ratio 75 to 100 volume%). Lithium borofluoride (LiBF₄) dissolved in the non-aqueous solvent is an electrolyte with a high decomposition temperature, which also greatly improves the heat resistance. The LiBF₄ concentration in the electrolytic solution 22 should preferably be 0.5 to 2 mol/L, more preferably 0.6 to 1.9 mol/L, even more preferably 0.7 to 1.7 mol/L, and particularly preferably 0.8 to 1.5 mol/L.

The electrolytic solution 22 may further contain vinylene carbonate (VC) and/or fluoroethylene carbonate (FEC) and/or vinyl ethylene carbonate (VEC) as additives. Both VC and FEC have excellent heat resistance. Therefore, by including such additives in the electrolytic solution 22, an SEI membrane with excellent heat resistance can be formed on the surface of the negative electrode layer 16.

The battery container 24 is provided with a sealed space, and the positive electrode layer 12, the negative electrode layer 16, the separator 20, and the electrolytic solution 22 are housed in the sealed space. The battery container 24 may be appropriately selected according to the type of the lithium-ion secondary battery 10. For example, if the lithium-ion secondary battery is in the form of a coin-cell battery as illustrated in Fig. 1, the battery container 24 typically includes a positive electrode can 24a, a negative electrode can 24b, and a gasket 24c, wherein the positive electrode can 24a and the negative electrode can 24b are swaged via the gasket 24c to form the sealed space. The positive electrode can 24a and the negative electrode can 24b may be made of a metal such as stainless steel, and are not particularly limited. The gasket 24c may be an annular member made of an insulating resin such as polypropylene, polytetrafluoroethylene, PFA resin, etc., and is not particularly limited.

The lithium-ion secondary battery 10 should preferably be further provided with the positive-electrode current collector 14 and/or the negative-electrode current collector 18. The positive-electrode current collector 14 and the negative-electrode current collector 18 are not particularly limited, but should preferably be metal foils such as copper foils or aluminum foils. The positive-electrode current collector 14 should preferably be placed between the positive electrode layer 12 and the battery container 24 (for example, the positive electrode can 24a), and the negative-electrode current collector 18 should preferably be located between the negative electrode layer 16 and the battery container 24 (for example, the negative electrode can 24b). Furthermore, the positive-electrode-side carbon layer 13 should preferably be provided between the positive electrode layer 12 and the positive-electrode current collector 14 from the viewpoint of reducing the contact resistance. Similarly, the negative-electrode-side carbon layer 17 should preferably be provided between the negative electrode layer 16 and the negative-electrode current collector 18 from the viewpoint of reducing the contact resistance. Both the positive-electrode-side carbon layer 13 and the negative-electrode-side carbon layer 17 should preferably be made of conductive carbon, and may be formed, for example, by applying conductive carbon paste by screen printing, etc.

The battery element may be in the form of a cell stack having a plurality of unit cells including the positive electrode layer 12, the separator 20, and the negative electrode layer 16. The cell stack is not limited to a flat plate laminated structure in the form of stacked flat plates or layers, but can have a variety of laminated structures including the following examples. Incidentally, all of the configurations illustrated below should preferably be one integral sintered body of the cell stack as a whole.
- Folding structure: a laminated structure in which multilayers (with large area) are made by folding a sheet having a layer structure including unit cells and current collecting layers once or multiple times.
- Winding structure) : a laminated structure in which multilayers (with large area) are made by winding and integrating a sheet having a layer structure including unit cells and current collecting layers.
- Multi-layer ceramic capacitor (MLCC)-like structure: a laminated structure in which multilayers (with large area) are made by repeating stacking units of a current collector layer / a positive electrode layer / a ceramic separator layer / a negative electrode layer / a current collector layer in a thickness direction, and electricity is collected with a plurality of positive electrode layers on one side (e.g., left hand) and a plurality of the negative electrode layers on the other side (e.g., right hand).

### <Specific Examples>

Some specific examples of this embodiment will be explained. Incidentally, in the following examples, LiCoO₂ will be abbreviated as "LCO" and Li₄Ti₅O₁₂ will be abbreviated as "LTO."

### <<Example 1>>

### (1) Manufacture of LCO Green Sheet (Positive Electrode Green Sheet)

Firstly, after mixing Co₃O₄ powder (manufactured by SEIDO CHEMICAL INDUSTRY CO., LTD.) and Li₂CO₃ powder (manufactured by The Honjo Chemical Corporation) which were weighed so that a molar ratio of Li to Co would become 1.01, the mixture was retained at 780°C for five hours and the obtained powder was pulverized by a pot mill so that a volumetric basis D50 would become 0.4 µm, thereby obtaining powder made of LCO-plate-shaped particles. The obtained LCO powder (100 parts by weight), a dispersion medium (toluene : isopropanol = 1:1) (100 parts by weight), a binder (polyvinyl butyral; product number: BM-2; and manufactured by SEKISUI CHEMICAL CO., LTD.) (10 parts by weight), a plasticizer (DOP: di(2-ethylhexyl)phthalate manufactured by KUROGANE KASEI Co., Ltd.) (4 parts by weight), and a dispersant (product name: RHEODOL SP-O30 manufactured by Kao Corporation) (2 parts by weight) were mixed. The obtained mixture was stirred and defoamed under reduced pressure and its viscosity was adjusted to 4000 cP, thereby preparing an LCO slurry. The viscosity was measured by an LVT-type viscometer manufactured by Brookfield. The thus-prepared slurry was formed into a sheet shape on a PET film by a doctor blade method, thereby forming an LCO green sheet. The thickness of the LCO green sheet was set so that the thickness after calcination would become 60 µm.

### (2) Manufacture of LTO Green Sheet (Negative Electrode Green Sheet)

Firstly, LTO powder (volumetric basis: D50; particle size: 0.06 µm; and manufactured by Sigma-Aldrich Japan) (100 parts by weight), the dispersion medium (toluene : isopropanol = 1:1) (100 parts by weight), the binder (polyvinyl butyral: product number: BM-2; and manufactured by SEKISUI CHEMICAL CO., LTD.) (20 parts by weight), the plasticizer (DOP: di(2-ethylhexyl)phthalate manufactured by KUROGANE KASEI Co., Ltd.) (4 parts by weight), and a dispersant (product name: RHEODOLSP-O30 manufactured by Kao Corporation) (2 parts by weight) were mixed. The obtained negative-electrode raw material mixture was stirred and defoamed under reduced pressure and its viscosity was adjusted to 4000 cP, thereby preparing an LCO slurry. The viscosity was measured by the LVT-type viscometer manufactured by Brookfield. The thus-prepared slurry was formed into a sheet shape on a PET film by the doctor blade method, thereby forming an LCO green sheet. The thickness of the LCO green sheet was set so that the thickness after calcination would become 70 µm.

### (3) Manufacture of MgO Green Sheet (Separator Green Sheet)

A heat treatment was applied to magnesium carbonate powder (manufactured by Konoshima Chemical Co., Ltd.) at 900°C for five hours, thereby obtaining MgO powder. The obtained MgO powder and glass frit (manufactured by Japan Frit K.K., CK0199) were mixed at a weight ratio of 4:1. The obtained mixed powder (volumetric basis: D50; and particle size: 0.4 µm) (100 parts by weight), the dispersion medium (toluene: isopropanol = 1:1) (100 parts by weight), the binder (polyvinyl butyral; product number: BM-2; and manufactured by SEKISUI CHEMICAL CO., LTD.) (20 parts by weight), the plasticizer (DOP: di(2-ethylhexyl)phthalate; and manufactured by KUROGANE KASEI Co., Ltd.) (4 parts by weight), and the dispersant (product name: RHEODOL SP-O30; and manufactured by Kao Corporation) (2 parts by weight) were mixed. The obtained raw material mixture was stirred and defoamed under reduced pressure and its viscosity was adjusted to 4000 cP, thereby preparing a slurry. The viscosity was measured by the LVT-type viscometer manufactured by Brookfield. The thus-prepared slurry was formed into a sheet shape on a PET film by the doctor blade method, thereby forming a separator green sheet. The thickness of the separator green sheet was set so that the thickness after calcination would become 25 µm.

### (4) Stacking, Pressure Bonding, and Calcination

The LCO green sheet (positive electrode green sheet), the MgO green sheet (separator green sheet), and the LTO green sheet (negative electrode green sheet) were sequentially stacked and the obtained stack was pressed together at 200 kgf/cm² by a CIP (cold isostatic pressing method) to pressure-bond the green sheets together. The thus-pressure-bonded stack was punched into a disk shape with a diameter of 10 mm by a punching die. The obtained disk-shaped stack was degreased at 600°C for five hours, and then the temperature was increased at 1000°C/h to 800°C, which was then retained for 10 minutes to perform calcination, and then was cooled down. Consequently, one integrated sintered body plate including three layers, that is, a positive electrode layer (LCO sintered body layer), a ceramic separator (MgO separator), and a negative electrode layer (LTO sintered body layer) was obtained.

### (5) Manufacture of Lithium-Ion Secondary Battery

The coin-shaped lithium-ion secondary battery 10 like the one schematically illustrated in Fig. 1 was manufactured as described below.

### (5a) Bonding the negative electrode layer and the negative-electrode current collector with conductive carbon paste

Conductive carbon paste was prepared as a conductive adhesive agent by weighing acetylene black and polyimide amide to achieve a mass ratio of 3:1 and mixing them with an appropriate amount of NMP (N-Methyl-2-Pyrrolidone) as a solvent. The conductive carbon paste was screen-printed on an aluminum foil as a negative-electrode current collector. The integrated sintered body manufactured in section (4) described above was placed to cause the negative electrode layer to be fit within an undried print pattern (that is, an area pasted with the conductive carbon paste), and was vacuum-dried at 60°C for 30 minutes, thereby manufacturing a structure in which the negative electrode layer and the negative-electrode current collector are bonded together via the negative-electrode-side carbon layer. Incidentally, the thickness of the negative-electrode-side carbon layer was set as 10 µm.

### (5b) Preparation of Positive-Electrode Current Collector with Carbon Layer

Conductive carbon paste was prepared by weighing acetylene black and polyimide amide to achieve a mass ratio of 3:1 and mixing them with an appropriate amount of NMP (N-Methyl-2-Pyrrolidone) as a solvent. The conductive carbon paste was screen-printed on an aluminum foil as a positive-electrode current collector, which was then vacuum-dried at 60°C for 30 minutes, thereby manufacturing the positive-electrode current collector with a positive-electrode-side carbon layer formed on its surface. Incidentally, the thickness of the positive-electrode-side carbon layer was set as 5 µm.

### (5c) Assembly of Coin-Cell Battery

The positive-electrode current collector, the positive-electrode-side carbon layer, the integrated sintered body plate (the LCO positive electrode layer, the MgO separator, and the LTO negative electrode layer), the negative-electrode-side carbon layer, and the negative-electrode current collector were placed between a positive electrode can and a negative electrode can, which would configure a battery case, and were stacked in the sequential order listed above from the positive electrode can towards the negative electrode can, and the inside of the positive electrode can and the negative electrode can was filled with an electrolytic solution, and the positive electrode can and the negative electrode can were swaged via a gasket and were thereby sealed together. Consequently, a coin-cell-shaped lithium-ion secondary battery 10 with a diameter of 12 mm and a thickness of 1.0 mm was manufactured. Under this circumstance, a liquid obtained by dissolving LiBF4 in an organic solvent, which was obtained by mixing ethylene carbonate (EC) and γ-butyrolactone (GBL) at a volume ratio of 1:3, to achieve concentration of 1.5 mol/L was used as the electrolytic solution.

### (6) Measurement of Capacity Retention Rate after Storage

A capacity retention rate after storage of the battery was measured by the following procedures. Firstly, constant voltage charging was performed at 2.7 V under the environment of 25°C and then electric discharge was performed at an electric discharge rate of 0.2C, thereby measuring an initial capacity. Next, the battery was retained for 50 days in a state where a voltage of 2.7 V was applied under the environment of 60°C. Lastly, the capacity after storage was measured by performing constant voltage charging at 2.7 V and then performing electric discharge at 0.2C. The capacity retention rate (%) after the storage was obtained by dividing the measured capacity after storage by the initial capacity and then multiplying the obtained quotient by 100.

### (7) Dismantling, Cleaning, and Reassembly of Stored Battery

The stored battery was prepared and its sealed part where the positive electrode can and the negative electrode can were swaged was opened. Next, the negative electrode can and the gasket were removed from the battery and the positive-electrode current collector, the integrated sintered board, and the negative-electrode current collector were taken out from inside the battery. Then, the positive-electrode current collector was removed from the integrated sintered board, which has been taken out, and the integrated sintered board to which the negative-electrode current collector was bonded was immersed in an appropriate amount of NMP (N-Methyl-2-Pyrrolidone) and was stirred for 60 minutes, thereby causing the positive-electrode-side carbon layer and the negative-electrode-side carbon layer, which were bonded to the integrated sintered board, and impurities such as electrolytic solution decomposition products which are attached to the integrated sintered board, to dissolve and be removed and, at the same time, peeling off the negative-electrode current collector. The same work was repeated twice and the integrated sintered board, from which the impurities were removed, was vacuum-dried at 120°C for 12 hours. Next, the vacuum-dried integrated sintered board was reassembled as a coin-cell battery through procedures (5a), (5b), and (5c).

### (8) Capacity Retention Rate of Reassembled Battery

A capacity retention rate of the reassembled battery was measured according to the following procedures. Firstly, the constant voltage charging was performed at 2.7 V under the environment of 25°C and the electric discharge was performed at the electric discharge rate of 0.2C, thereby measuring the capacity after reassembly. The capacity retention rate (%) after the reassembly was obtained by dividing the measured capacity after reassembly by the initial capacity and then multiplying the obtained quotient by 100.

### <<Example 2>>

The reassembled battery was evaluated in a manner similar to Example 1, except that the vacuum-dried integrated sintered board was heated at 600°C for five hours and thereby degreased and was then used to reassemble the battery.

### <<Example 3>>

The reassembled battery was evaluated in a manner similar to Example 2, except that the degreased integrated sintered board was calcinated at 800°C for 10 minutes and was then used to reassemble the battery.

### «Example 4 (Comparison)»

The reassembled battery was evaluated in a manner similar to Example 1, except that only the replacement of the electrolytic solution was performed without performing electrode restoration processing (cleaning and drying) after dismantling the battery.

### «Example 5 (Comparison)»

The battery was manufactured and subsequent steps and evaluation were performed in a manner similar to Example 1, except that: a) a commercially available LCO-coated electrode (manufactured by Hohsen Corp.) was used as the positive electrode plate instead of the LCO sintered body plate; b) a carbon-coated electrode on a negative-electrode current collector manufactured through the procedures described below was used as the negative electrode plate and the negative-electrode current collector; and c) a cellulose separator was used as the separator.

### (Manufacture of Carbon-Coated Electrode)

Paste including a mixture of graphite as an active material and polyvinylidene fluoride (PVDF) as a binder was applied to a surface of the negative-electrode current collector (aluminum foil), which was then dried, thereby manufacturing a carbon-coated electrode equipped with a carbon layer with the thickness of 280 µm.

### «Evaluation Results»

Table 1 shows the evaluation results of Examples 1 to 5.

### [Table 1]

**Table 1**

| | Electrode | Electrode Restoration Processing | | | Evaluation | |
|---|---|---|---|---|---|---|
| | Type | Cleaning and Drying | Degreasing | Calcination | Capacity Retention Rate After Storage (%) | Capacity Retention Rate After Reassembly (%) |
| Ex. 1 | Ceram ic Electrode | Yes | No | No | 82 | 92 |
| Ex. 2 | Ceram ic Electrode | Yes | Yes | No | 83 | 94 |
| Ex. 3 | Ceram ic Electrode | Yes | Yes | Yes | 82 | 95 |
| Ex. 4* | Ceram ic Electrode | No | No | No | 82 | 84 |
| Ex. 5* | Coated Electrode | Yes | No | No | 71 | 30 |

| | | | | | | |
|---|---|---|---|---|---|---|
| The mark * indicates a comparative example. | | | | | | |

As can be seen from the results indicated in Table 1, Examples 1 to 3 show considerable recovery of the capacity retention rate with the effect of, for example, removing the impurities by the electrode restoration processing. On the other hand, Example 4 which is a comparative example in which only the replacement of the electrolytic solution was performed does not show any considerable improvement of the capacity retention rate. Moreover, in Example 5 which is a comparative example using the coated electrode (including the binder or the like), degradation occurred due to, for example, desorption of the active material in the cleaning step.

One example of the lithium-ion secondary battery having the ceramic electrode and the method for reusing the lithium-ion secondary battery have been explained above.

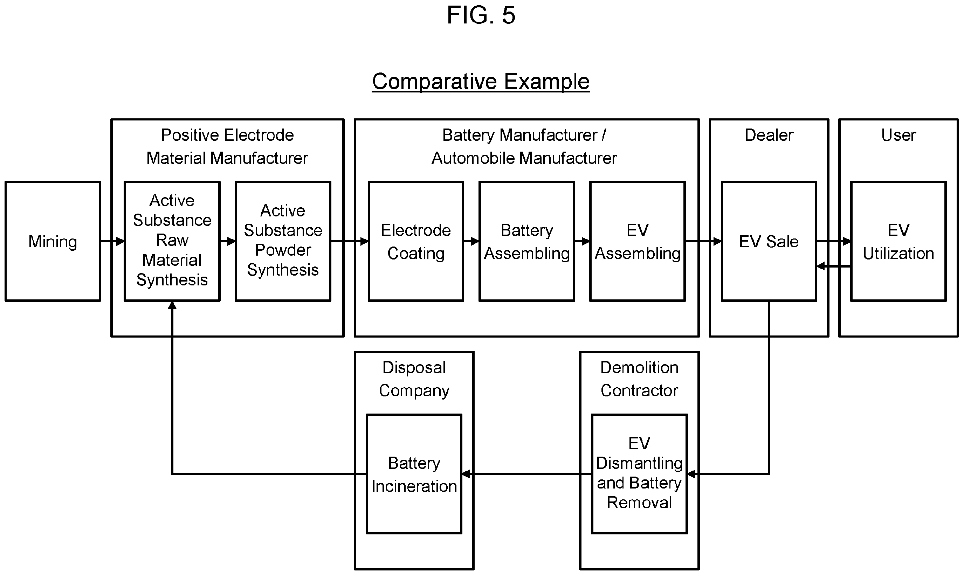

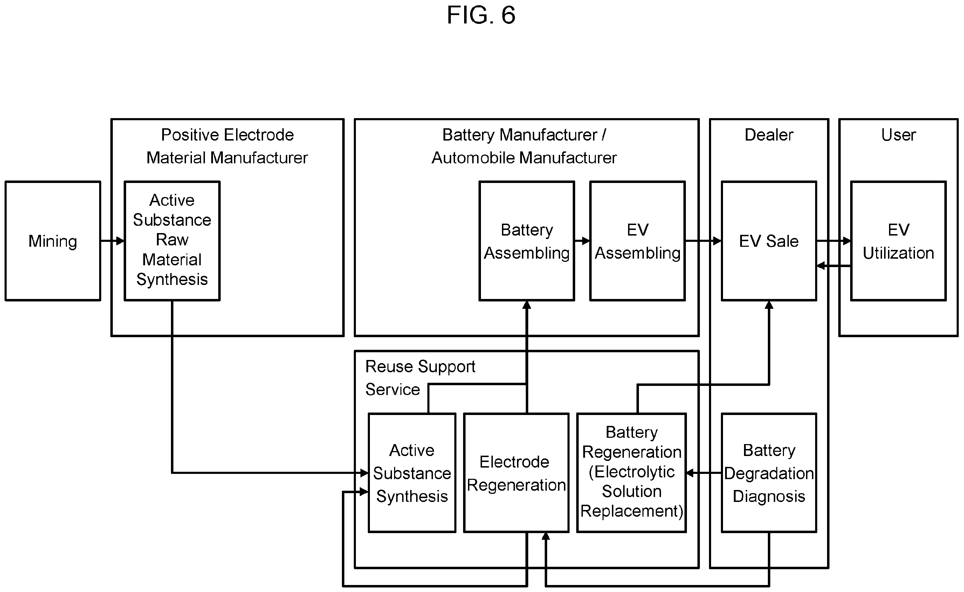

Referring to Fig. 5 and Fig. 6, an explanation will be provided about a value change according to one comparative example based on an assumption to reuse the conventional lithium-ion secondary battery by taking an electric automobile (EV) as an example, and a value chain expected for the reuse of the lithium-ion secondary battery according to this embodiment.

Regarding the value chain according to one comparative example as illustrated in Fig. 5, an EV was returned from a user who used the EV to a dealer and that EV is sent to a demolition contractor. The demolition contractor dismantles the EV to remove the lithium-ion secondary battery and the removed lithium-ion secondary battery is sent to a disposal company. The disposal company deletes the lithium-ion secondary battery to extract metal and the extracted metal is sent to a positive electrode material manufacturer. The positive electrode material manufacturer can synthesize an active substance raw material by using that metal.

Consequently, according to one comparative example, each lithium-ion secondary battery is incinerated to extract a metal element, thereby implementing recycling. Since this has to go through complicated processes, it requires high cost.

Moreover, according to one comparative example, the current collector hinders movements of the electrolytic solution between the electrode layers, so that it is difficult for the electrolytic solution to be discharged and permeate.

On the other hand, the value chain illustrated in Fig. 6 is expected in this embodiment. The main difference from one comparative example is as described as follows. Incidentally, for ease of explanation, the lithium-ion secondary battery according to this embodiment (the lithium-ion secondary battery having the ceramic electrode) may be sometimes hereinafter simply referred to as the "battery."
(A) Regarding the used battery of the EV which was returned from the user to the dealer, a degradation degree of the battery is diagnosed. Incidentally, an owner of the battery may be the user or anyone other than the user (for example, the battery in the EV may be leased). Incidentally, in this embodiment, the "used battery" means a battery which is not new, that is, a battery which has been used even a little.
(B) If the degradation degree of the battery is less than a specified value, regeneration of the battery is performed. Specifically, the electrolytic solution of the battery is replaced. Since this battery does not have the current collector which is easily permeable, it is easy to replace the electrolytic solution.
(C) If the degradation degree of the battery is equal to or more than the specified value, the degradation degree of the ceramic electrode of the battery is diagnosed. If the degradation degree is a certain degree to enable regeneration, regeneration processing is applied to the ceramic electrode and then the battery is assembled. The electrode is a ceramic electrode and can be taken out as it is, so that the electrode can be regenerated. Incidentally, if the degradation degree of the ceramic electrode of the battery is not a certain degree that enables the regeneration, for example, pulverization of the electrode is performed and then the active substance synthesis is performed and the electrode and the battery are assembled.

In this embodiment, a reuse support system that is a computer system for supporting the reuse of the battery is constructed. The reuse support system may be a physical computer system (one or more computers) or a logical computer system (for example, a system as a cloud computing service) based on a physical computer system (for example, a cloud infrastructure having a plurality of types of computing resources).

This embodiment will be explained below in more detail. Incidentally, in the following explanation, the ceramic positive electrode layer 12 will be taken as an example of the ceramic electrode. Since the ceramic electrode is taken out to be reused, the ceramic positive electrode layer 12 will be referred to as a "ceramic positive electrode 12" in the explanation below. The ceramic negative electrode layer 16 can be also referred to as a "ceramic negative electrode 16." The ceramic negative electrode layer 16 may be adopted as the ceramic electrode instead of or in addition to the ceramic positive electrode 12. Incidentally, the ceramic electrode(s) (the ceramic positive electrode 12 or/and the ceramic negative electrode 16) may be the one with primary particles which have crystal orientation of a specified angle or the one with random primary particles (which are not oriented at a specified angle).

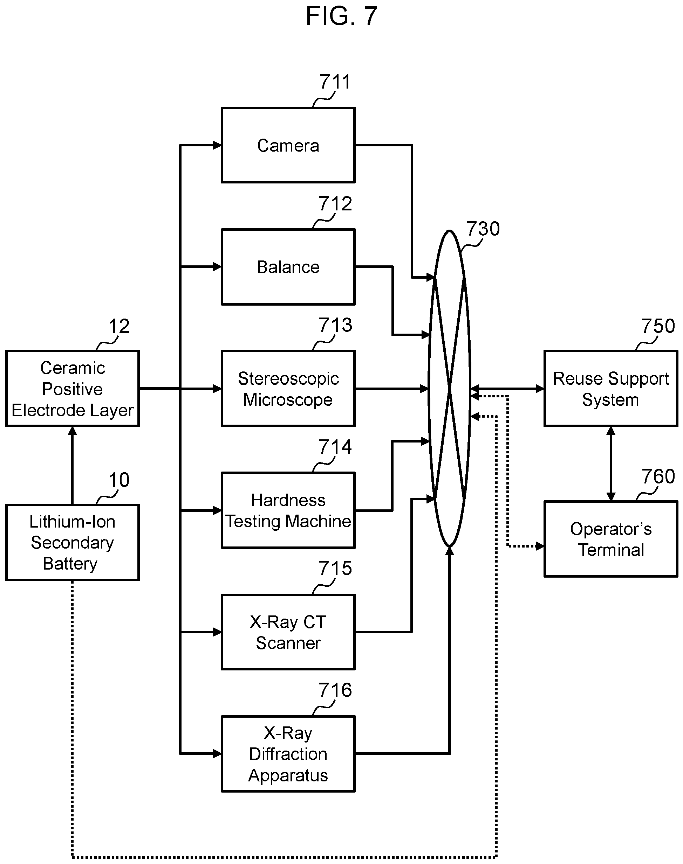

Fig. 7 is a configuration diagram of the entire reuse system including the reuse support system according to this embodiment.

The reuse system includes one or a plurality of diagnosis support apparatuses and a reuse support system 750. The diagnosis support apparatus is an apparatus obtained by a method for capturing images of, measuring, testing, or analyzing diagnosis data which are data to be used for diagnosis of the lithium-ion secondary battery 10 or the ceramic positive electrode 12 (specifically, the ceramic positive electrode 12 taken out of the battery 10). The reuse support system 750 typically receives the diagnosis data, which are obtained by each of the one or plurality of diagnosis support apparatuses, via a communication network 730. The communication network 110 is, for example, the Internet, a WAN (Wide Area Network), or a LAN (Local Area Network).

An apparatus for obtaining the diagnosis data of the ceramic positive electrode 12 is adopted as the diagnosis support apparatus. Furthermore, an apparatus for obtaining the diagnosis data as data to be used to diagnose a degradation mode of the battery 10 (to diagnose whether the electrode or the electrolytic solution has degraded) may be adopted as the diagnosis support apparatus.

The "diagnosis" of the ceramic positive electrode 12 includes a degradation degree judgment and a regeneration processing content decision which will be described later. At least one of a camera 711 and a balance 712 (one example of a weight measuring machine) is adopted as the diagnosis support apparatus for the degradation degree judgment. At least one of a stereoscopic microscope 713, a hardness testing machine 714, an X-ray CT scanner 715, and an X-ray diffraction apparatus 716 is adopted as the diagnosis support apparatus for the regeneration processing content decision.

Other kinds of diagnosis support apparatuses may be adopted as the diagnosis support apparatus(es) instead of or in addition to at least some of the aforementioned diagnosis support apparatuses. The data obtained by the diagnosis support apparatus may be input to the reuse support system 750 by any one of the following methods (or other methods).
- The diagnosis support apparatus has a communication function. The communication function transmits data. The transmitted data is transmitted to the reuse support system 750 over the communication network 730 via or not via an edge apparatus such as a gateway apparatus.
- An information processing terminal (for example, a personal computer or a smartphone) receives data from the diagnosis support apparatus (or receives the input of data indicating the result of measurement, etc. by the diagnosis support apparatus from an operator) and transmits the data to the reuse support system 750 via or not via the communication network 730. The information processing terminal may be, for example, the operator's terminal 760 described later.

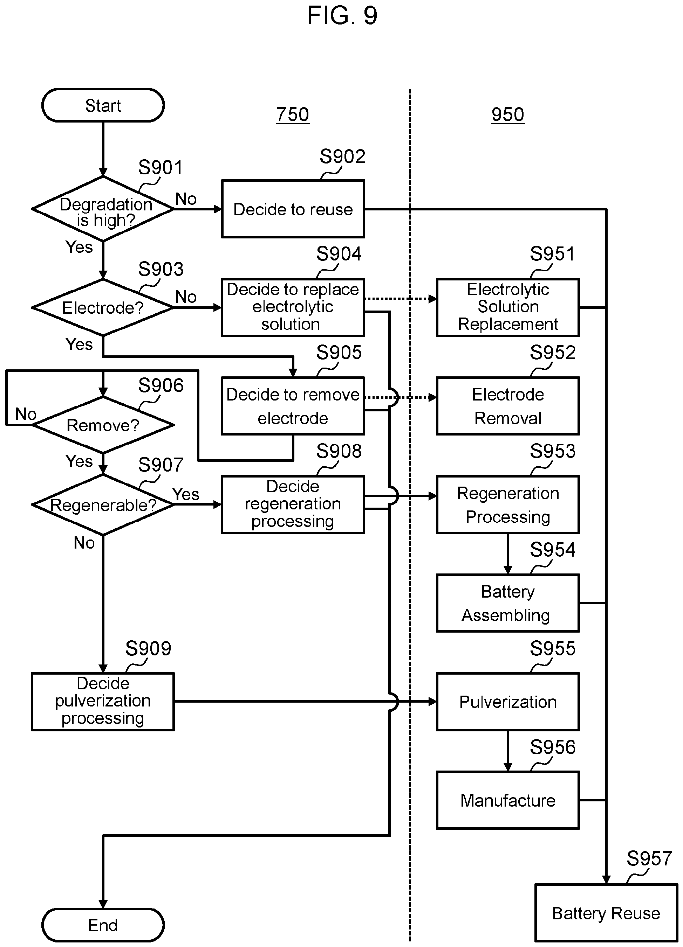

Moreover, the data for the diagnosis of the degradation degree of the battery 10 itself may not be input to the reuse support system 750, but may be measured at a site of, for example, a dealer to diagnose the degradation degree of the battery 10. In this embodiment, the battery diagnosis (for example, S901 in Fig. 9 described later) that is the diagnosis of the degradation degree of the battery 10 is performed by the reuse support system 750. For example, the battery 10 may be provided with an IoT device (which is not illustrated in the drawing) for the diagnosis of the degradation degree of the battery 10. The IoT device may transmit diagnosis data indicating a degradation index value of the battery 10 to the reuse support system 750 and the reuse support system 750 may perform the battery diagnosis based on the diagnosis data. Incidentally, the "degradation index value" is a value obtained regarding the battery 10 as an index for a degraded state of the battery 10. The degradation index value may be a value measured regarding the battery 10 or a value calculated based on the value measured regarding the battery 10. Specifically, for example, the degradation index value may be at least one of a resistance value (internal resistance value), an output electric current value, and duration until a voltage reduction of the battery 10. Moreover, instead of the reuse support system 750 performing the battery diagnosis, the IoT device may perform the battery diagnosis and transmit the result of the diagnosis (whether the degradation is high or not) to the reuse support system 750.

Of the reuse support system 750 (for example, a server) and the operator's terminal 760 (for example, a client) which is an information processing terminal used for the operation of the reuse support system 750, for example, the operator's terminal 760 exists at a company which provides the reuse support service. The reuse support system 750 performs at least an electrode diagnosis, among the battery diagnosis and the electrode diagnosis, in response to an instruction from the operator's terminal 760 (or automatically without the instruction).

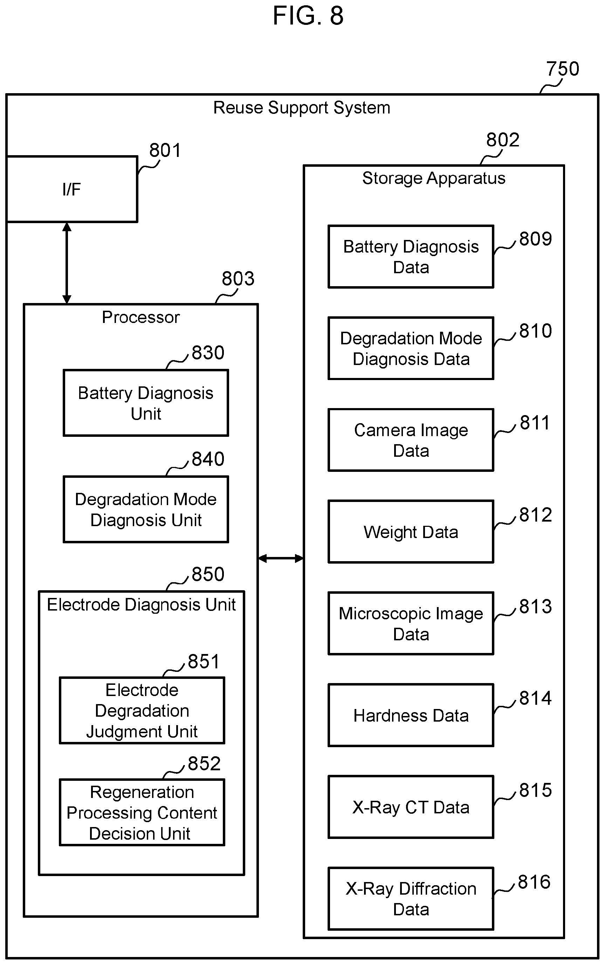

Fig. 8 is a configuration diagram of the reuse support system 750.

The reuse support system 750 includes an interface apparatus 801, a storage apparatus 802, and a processor 803 connected to them.

Data are transmitted and received via the interface apparatus 801. For example, the diagnosis data is received and the diagnosed data is stored in the storage apparatus 802.

The storage apparatus 802 stores programs and data. The stored data are, for example, battery diagnosis data (data indicating the degradation index value of the battery 10) 809 for the battery diagnosis, diagnosis data 810 of the degradation mode, and diagnosis data of the electrode diagnosis. As the diagnosis data for the electrode diagnosis, for example, there are (A) and (B) as follows.
(A) At least one kind of data among camera image data 811 and weight data 812 (an example of one or a plurality of kinds of first data).
(B) At least one kind of data among microscopic image data 813, hardness data 814, X-ray CT data 815, and X-ray diffraction data 816 (one or a plurality of kinds of second data).

The camera image data 811 is data indicating an image(s) captured by the camera 711 (captured images of the removed ceramic positive electrode 12). The weight data 812 is data indicating the weight measured by the balance 712 (the weight of the removed ceramic positive electrode 12). The microscopic image data 813 is data indicating an image(s) captured by the stereoscopic microscope 713 (an image(s) of an outermost surface of the removed ceramic positive electrode 12). The hardness data 814 is data indicating hardness measured by the hardness testing machine 714 (the hardness of the removed ceramic positive electrode 12). The X-ray CT data 815 is data indicating an image(s) captured by the X-ray CT scanner 715 (an image(s) of an internal structure of the removed ceramic positive electrode 12). The X-ray diffraction data 816 is data indicating the result of the X-ray diffraction by the X-ray diffraction apparatus 716 (for example, data indicating at least one of a crystal structure, crystallinity, and heterogenous phase identification of the outermost surface of the ceramic positive electrode 12).

Functions such as a battery diagnosis unit 830, a degradation mode diagnosis unit 840, and an electrode diagnosis unit 850 are implemented by execution of programs by the processor 803.

The battery diagnosis unit 830 judges the battery diagnosis, specifically, the degradation degree of the battery 10 based on the battery diagnosis data 809.

The degradation mode diagnosis unit 840 judges, based on the degradation mode diagnosis data 810, whether the degradation mode of the battery 10 is the ceramic positive electrode 12 or the electrolytic solution.

The electrode diagnosis unit 850 performs the electrode diagnosis based on at least one kind of data among the data 811 through 816. Specifically, the electrode diagnosis unit 850 has an electrode degradation diagnosis unit 851 and a regeneration processing content decision unit 852. The electrode degradation diagnosis unit 851 performs an electrode degradation judgment, based on at least one kind of data among the data 811 and 812, to judge whether or not the degradation degree of the removed ceramic positive electrode layer 12 satisfies a condition(s) for enabling regeneration of the ceramic electrode layer. The regeneration processing content decision unit 852 evaluates each of one or a plurality of evaluation items of the ceramic electrode layer on the basis of the data 813 through 816 and decides the content of regeneration processing to be applied to the removed ceramic positive electrode layer 12 on the basis of the evaluation result(s) of the one or plurality of evaluation items.

An explanation will be provided about a flow of the battery reuse to be performed according to this embodiment.

Fig. 9 is a flowchart illustrating a flow of reusing the battery 10. Incidentally, processing S951 through S957 indicated by blocks located in an area indicated with the reference numeral 950 is performed by at least either a system other than the reuse support system 750 or manual operation.

The battery diagnosis unit 830 judges, based on the battery diagnosis data 809, whether the degradation degree of the battery 10 exceeds a specified degree or not (S901). If the judgment result of S901 is false (S901: No), the battery diagnosis unit 830 decides to reuse the battery 10 (S902) and transmits, for example, the judgment result of S901 or information indicating the decision to reuse the battery 10 to the operator's terminal 760. In this case, the battery 10 is reused as it is (or after specified maintenance) (S957).

If the judgment result of S901 is true (S901: Yes), the degradation mode diagnosis unit 840 judges, based on the degradation mode diagnosis data 810, whether the degradation mode of the battery 10 is the ceramic positive electrode 12 or not (that is, the electrolytic solution) (S903).

If the judgment result of S903 is false (S903: No), the degradation mode diagnosis unit 840 decides to replace the electrolytic solution (S904) and transmits, for example, the judgment result of S903 or information indicating the decision to replace the electrolytic solution to the operator's terminal 760. In this case, the electrolytic solution is replaced (S951) and then the battery 10 is reused (S957).

If the judgment result of S903 is true (S903: Yes), the degradation mode diagnosis unit 840 decides to remove the ceramic positive electrode 12 (S905) and transmits, for example, the judgment result of S903 or information indicating the decision to remove the ceramic positive electrode 12 to the operator's terminal 760. In this case, the battery 10 is dismantled and the ceramic positive electrode 12 is removed (S952). The electrode diagnosis is performed regarding the ceramic positive electrode 12 removed from the battery 10. Incidentally, the electrode diagnosis may be performed regarding the ceramic positive electrode 12 which is removed from the battery 10 and to which specified processing is further applied (for example, which is cleaned). Specifically speaking, the "removed ceramic positive electrode 12" in the following explanation may be the ceramic positive electrode 12 to which cleaning and/or other processing is applied after being removed.

If the electrode diagnosis unit 850 recognizes, based on the data from a sensor or the operator's terminal 760 that the ceramic positive electrode 12 has been removed (S906: Yes), the electrode degradation judgment unit 851 for the electrode diagnosis unit 850 performs the electrode degradation judgment to judge, based on at least one kind of data among the data 811 and 812, whether or not the degradation degree of the removed ceramic positive electrode layer 12 satisfies a condition(s) for enabling regeneration of the ceramic electrode layer (S907).

If the judgment result of S907 is true (S907: Yes), the regeneration processing content decision unit 852 evaluates each of one or a plurality of evaluation items of the ceramic electrode layer on the basis of the data 813 through 816 and decides the content of regeneration processing to be applied to the removed ceramic positive electrode layer 12 on the basis of the evaluation result(s) of the one or plurality of evaluation items (S908). For example, the regeneration processing content decision unit 852 transmits information indicating the decided content of the regeneration processing to at least one of the operator's terminal 760 and an apparatus for performing the regeneration processing (which is not illustrated in the drawing). In this case, the regeneration processing with the decided processing content is applied to the ceramic positive electrode 12 (S953). Then, the battery 10 including the ceramic positive electrode 12 is assembled (S954) and the reuse of the battery 10 is implemented (S957).

If the judgment result of S907 is false (S907: No), the electrode degradation judgment unit 851 decides pulverization processing of the battery 10 (S909) and transmits, for example, the judgment result of S907 or information indicating the decision of the pulverization processing of the battery 10 to the operator's terminal 760. In this case, the pulverization processing of the battery 10 is performed (S955), the battery 10 is manufactured (S956), and the battery 10 is reused (S957).

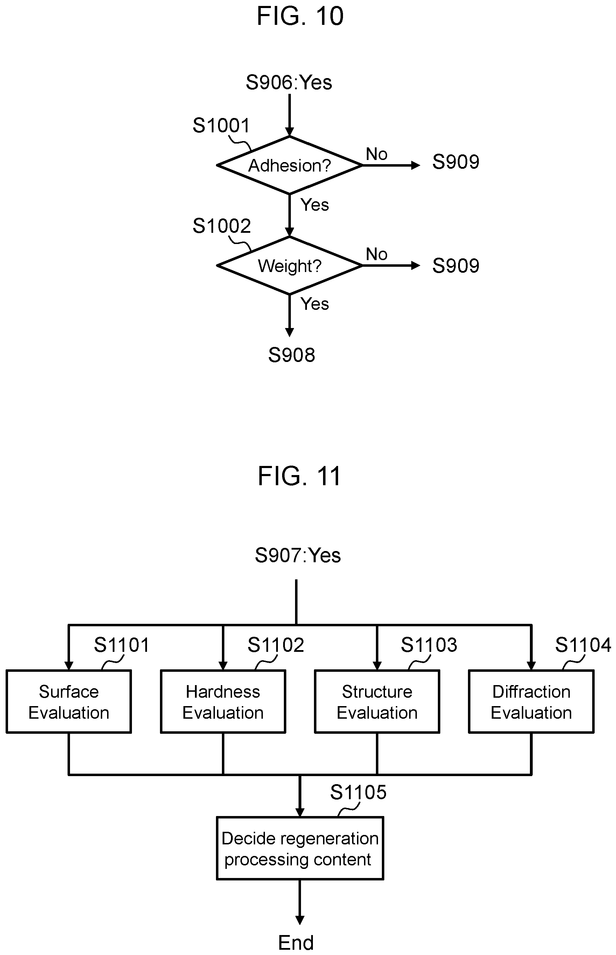

Fig. 10 is a flowchart illustrating the details of S907 in Fig. 9.

The electrode degradation judgment unit 851 judges, based on the camera image data 811, whether a degree of adhesion to the ceramic positive electrode 12 is less than a specified degree or not (S1001).

If the judgment result of S1001 is false (S1001: No), the judgment result of S907 is false and, as a result, S909 is performed. In this case, for example, the electrode degradation judgment unit 851 may decide to forcibly remove attached substances in S909.

If the judgment result of S1001 is true (S1001: Yes), the electrode degradation judgment unit 851 judges whether the weight indicated by the weight data 812 is equal to or more than a specified weight or not (S1002). The judgment of S1002 is to judge, for example, whether or not the ceramic positive electrode 12 is maintained by, for example, the removal and cleaning of the ceramic positive electrode 12 (whether there is any damage or not). The judgments of S1001 and S1002 may be performed parallelly or S1002 may be performed first.

If the judgment result of S1002 is false (S1002: No), the judgment result of S907 is false and, as a result, S909 is performed.

If the judgment result of S1002 is true (S1002: Yes), the judgment result of S907 is true and S908 is performed.

Fig. 11 is a flowchart illustrating the details of S908 in Fig. 9.

The regeneration processing content decision unit 852 performs surface evaluation (S1101), hardness evaluation (S1102), structure evaluation (S1103), and diffraction evaluation (S1104).

The surface evaluation (S1101) is performed based on the microscopic image data 813. The microscopic image data 813 is data indicating the captured image(s) of the outermost surface of the removed ceramic positive electrode 12 by the microscope. The surface evaluation is performed based on microstructure observation results of the outermost surface of the ceramic positive electrode 12. For example, a degree of cracks in the outermost surface of the ceramic positive electrode 12 is evaluated.

The hardness evaluation (S1102) is performed based on the hardness data 814. The hardness data 814 is data indicating the hardness measured by the hardness testing machine 714 (the hardness of the removed ceramic positive electrode 12). The hardness data 814 indicates, as the hardness, for example, the size of a mark (for example, a hole) generated as a result of a behavior when a specified member is being pushed into the ceramic positive electrode 12, or as a result of the specified member pushed into the ceramic positive electrode 12. The hardness is evaluated.

The structure evaluation (S1103) is performed based on the X-ray CT data 815. The X-ray CT data 815 is data indicating an image(s) captured by the X-ray CT scanner 715 (an image(s) of the internal structure of the removed ceramic positive electrode 12). The X-ray CT data 815 corresponds to visualization data of the microstructure inside the ceramic positive electrode 12 and the degree of internal cracks in the ceramic positive electrode 12 is evaluated based on that data.

The diffraction evaluation (S1104) is performed based on the X-ray diffraction data 816. The X-ray diffraction data 816 is data indicating the results of the X-ray diffraction by the X-ray diffraction apparatus 716 (for example, data indicating at least one of the crystal structure, the crystallinity, and the heterogenous phase identification of the outermost surface of the ceramic positive electrode 12). At least one of the crystal structure, the crystallinity, and the heterogenous phase identification of the outermost surface of the ceramic positive electrode 12 is evaluated based on the X-ray diffraction data 816.

The regeneration processing content decision unit 852 decides the content of the regeneration processing to be applied to the ceramic positive electrode 12 on the basis of the evaluation results of S1101 through S1104 (S1105). For example, the regeneration processing content decision unit 852 estimates a Li reduction degree and an Me (a constituent metal element such as Co or Ni) reduction degree on the basis of the evaluation results of S1101 through S1104 and decides a processing parameter group corresponding to the estimated Li reduction degree and Me (the constituent metal element such as Co or Ni) reduction degree with respect to the ceramic positive electrode 12 (for example, selects a parameter group corresponding to the estimated Li reduction degree and Me (the constituent metal element such as Co or Ni) reduction degree from among a plurality of processing parameter groups). The "processing parameter group" is one or more parameters regarding each of one or a plurality of kinds of processing in the regeneration processing, for example, parameters regarding Li-Me solution impregnation (for example, a concentration and a molar ratio) and parameters regarding a heat treatment (for example, a temperature and time).

One embodiment has been explained above and this is just an example given for the purpose of describing this invention, and it is not intended to limit the scope of the present invention only to this embodiment. Incidentally, the aforementioned explanation can be, for example, expressed as follows.

### [Expression 1]

A reuse support system including an electrode degradation judgment unit that performs an electrode degradation judgment to judge, based on one or a plurality of kinds of first data diagnosed regarding a ceramic electrode removed from a lithium-ion secondary battery having the ceramic electrode, whether or not a degradation degree of the removed ceramic electrode satisfies a condition for enabling regeneration of the ceramic electrode.

### [Expression 2]

The reuse support system according to Expression 1, further including a regeneration processing content decision unit that, if a result of the electrode degradation judgment is true, evaluates each of one or a plurality of evaluation items of the ceramic electrode on the basis of one or a plurality of kinds of second data which are input regarding the removed ceramic electrode, and decides content of regeneration processing to be applied to the removed ceramic electrode on the basis of a result of the evaluation of the one or plurality of evaluation items.

### [Expression 3]

The reuse support system according to Expression 1 or 2,
wherein the one or plurality of kinds of first data include captured image data of the removed ceramic electrode;
wherein the electrode degradation judgment includes judging, based on the captured image data, whether or not a degree of adhesion to the removed ceramic electrode is less than a specified degree; and
wherein the result of the judgment being false is that a result of the electrode degradation judgment is false.

### [Expression 4]

The reuse support system according to any one of Expressions 1 to 3,
wherein the one or plurality of kinds of first data include weight data that is data indicating measured weight of the removed ceramic electrode;
wherein the electrode degradation judgment includes judging whether or not the weight indicated by the weight data is equal to or more than specified weight; and
wherein the result of the judgment being false is that a result of the electrode degradation judgment is false.

### [Expression 5]

The reuse support system according to Expression 2,
wherein the one or plurality of kinds of second data include at least one kind of data among the following:
(a) data of a captured image(s) of an outermost surface of the removed ceramic electrode by a microscope;
(b) data indicating hardness of the removed ceramic electrode;
(c) data indicating a captured image(s) of the removed ceramic electrode by X-ray CT; and
(d) data indicating a result of X-ray diffraction of the removed ceramic electrode.

### [Expression 6]

The reuse support system according to any one of Expressions 1 to 5,
further including a degradation mode judgment unit that judges whether a degradation mode of the lithium-ion secondary battery is an electrode or an electrolytic solution,
wherein if it is judged that the degradation mode is the electrolytic solution, the electrolytic solution of the lithium-ion secondary battery is replaced; and if it is judged that the degradation mode is the electrode, the electrode degradation judgment unit performs the degradation degree judgment.

### [Expression 7]

A reuse system including:
a lithium-ion secondary battery having a ceramic electrode; and
the reuse support system stated in any one of Expressions 1 to 6.

### [Expression 8]

A reuse support method including:
performing, by a computer, an electrode degradation judgment to judge, based on one or a plurality of kinds of first data which are input regarding a ceramic electrode that is an electrode for which a crystal-oriented ceramic plate is used, and which is removed from a lithium-ion secondary battery having the ceramic electrode, whether or not a degradation degree of the removed ceramic electrode satisfies a condition for enabling regeneration of the ceramic electrode; and
if a result of the electrode degradation judgment is true, evaluating, by the computer, each of one or a plurality of evaluation items of the ceramic electrode on the basis of one or a plurality of kinds of second data which are input regarding the removed ceramic electrode, and deciding content of regeneration processing to be applied to the removed ceramic electrode on the basis of a result of the evaluation of the one or plurality of evaluation items.

### REFERENCE SIGNS LIST

- 750:: reuse support system

## Claims

1. A reuse support system comprising an electrode degradation judgment unit that performs an electrode degradation judgment to judge, based on one or a plurality of kinds of first data diagnosed regarding a ceramic electrode removed from a lithium-ion secondary battery having the ceramic electrode, whether or not a degradation degree of the removed ceramic electrode satisfies a condition for enabling regeneration of the ceramic electrode.

2. The reuse support system according to claim 1,
further comprising a regeneration processing content decision unit that, if a result of the electrode degradation judgment is true, evaluates each of one or a plurality of evaluation items of the ceramic electrode on the basis of one or a plurality of kinds of second data which are input regarding the removed ceramic electrode, and decides content of regeneration processing to be applied to the removed ceramic electrode on the basis of a result of the evaluation of the one or plurality of evaluation items.

3. The reuse support system according to claim 1,
wherein the one or plurality of kinds of first data include captured image data of the removed ceramic electrode;
wherein the electrode degradation judgment includes judging, based on the captured image data, whether or not a degree of adhesion to the removed ceramic electrode is less than a specified degree; and
wherein the result of the judgment being false is that a result of the electrode degradation judgment is false.

4. The reuse support system according to claim 1,
wherein the one or plurality of kinds of first data include weight data that is data indicating measured weight of the removed ceramic electrode;
wherein the electrode degradation judgment includes judging whether or not the weight indicated by the weight data is equal to or more than specified weight; and
wherein the result of the judgment being false is that a result of the electrode degradation judgment is false.

5. The reuse support system according to claim 2,
wherein the one or plurality of kinds of second data include at least one kind of data among the following:
(a) data of a captured image of an outermost surface of the removed ceramic electrode by a microscope;
(b) data indicating hardness of the removed ceramic electrode;
(c) data indicating a captured image of the removed ceramic electrode by X-ray CT; and
(d) data indicating a result of X-ray diffraction of the removed ceramic electrode.

6. The reuse support system according to claim 1,
further comprising a degradation mode judgment unit that judges whether a degradation mode of the lithium-ion secondary battery is an electrode or an electrolytic solution,
wherein if it is judged that the degradation mode is the electrolytic solution, the electrolytic solution of the lithium-ion secondary battery is replaced; and
if it is judged that the degradation mode is the electrode, the electrode degradation judgment unit performs the degradation degree judgment.

7. A reuse system comprising:
a lithium-ion secondary battery having a ceramic electrode; and
the reuse support system stated in any one of claims 1 to 6.

8. A reuse support method comprising:
performing, by a computer, an electrode degradation judgment to judge, based on one or a plurality of kinds of first data which are input regarding a ceramic electrode that is an electrode for which a crystal-oriented ceramic plate is used, and which is removed from a lithium-ion secondary battery having the ceramic electrode, whether or not a degradation degree of the removed ceramic electrode satisfies a condition for enabling regeneration of the ceramic electrode; and
if a result of the electrode degradation judgment is true, evaluating, by the computer, each of one or a plurality of evaluation items of the ceramic electrode on the basis of one or a plurality of kinds of second data which are input regarding the removed ceramic electrode, and deciding content of regeneration processing to be applied to the removed ceramic electrode on the basis of a result of the evaluation of the one or plurality of evaluation items.
